Europäisches Patentamt

(19) European Patent Office

Office européen des brevets

(11) Publication number: **0 119 400**
**B1**

(12) **EUROPEAN PATENT SPECIFICATION**

(45) Date of publication of patent specification: 05.08.87

(51) Int. Cl.⁴: **H 01 L 29/78**

(21) Application number: **84100612.5**

(22) Date of filing: **20.01.84**

(54) **A vertical-type MOSFET and method of fabricating the same.**

(30) Priority: **17.02.83 JP 25335/83**
**17.02.83 JP 25336/83**
**17.02.83 JP 25337/83**

(43) Date of publication of application:
**26.09.84 Bulletin 84/39**

(45) Publication of the grant of the patent:
**05.08.87 Bulletin 87/32**

(84) Designated Contracting States:
**DE FR GB**

(56) References cited:
**EP-A-0 077 737**
**EP-A-0 112 607**
**WO-A-83/02852**
**DE-A-3 114 972**
**FR-A-2 476 914**
**GB-A-2 062 349**
**US-A-4 072 975**

(73) Proprietor: **NISSAN MOTOR CO., LTD.**
**No.2, Takara-cho, Kanagawa-ku**
**Yokohama-shi Kanagawa-ken 221 (JP)**

(72) Inventor: **Akiyama, Wataru**
**14-13, Onodai 7-chome**
**Sagamihara-shi Kanagawa-ken (JP)**
Inventor: **Hoshino, Shigeo**
**3-306, 1-11, Futaba**
**Yokosuka-shi Kanagawa-ken (JP)**
Inventor: **Mihara, Teruyoshi**
**13-305, 1-16, Futaba**
**Yokosuka-shi Kanagawa-ken (JP)**

(74) Representative: **Patentanwälte Grünecker, Dr.**
**Kinkeldey, Dr. Stockmair, Dr. Schumann, Jakob,**
**Dr. Bezold, Meister, Hilgers, Dr. Meyer-Plath**
**Maximilianstrasse 58**
**D-8000 München 22 (DE)**

Courier Press, Leamington Spa, England.

**Description**

The present invention relates to a vertical-type MOSFET comprising a semiconductor wafer functioning as drain region, a drain electrode joined to the lower surface of said wafer, a plurality of well regions formed in the upper surface of said wafer spaced from each other, a plurality of source regions each of which is formed in one of said well regions respectively, a gate electrode formed on said adjacent well regions and the portion of said wafer between said adjacent well regions and separated from the upper surface of said wafer by a gate insulating film and a source electrode electrically contacting said source regions; and a method for manufacturing said MOSFET.

Recently, it is strongly required to simplify driving circuits and integrate them thereby allowing the power supply voltage to the circuits to be lowered. So as to realize this requirement, there is a tendency that a power MOSFET particularly a vertical-type MOSFET which has a low conducting resistance, that means the resistance in the conducting state of the MOSFET, is suitable for a power switching element.

A MOSFET is known in accordance with the precharacterising parts of claims 1 and 5 from DE—A—3 114 972. WO—A—8 302 852 falling within the terms of Art. 54(3) shows a thyristor structure including a MOSFET in which the gate electrode is more distant from the drain drift region than from the channel region. The gate electrode does not cover the whole portion of the wafer between adjacent well regions. In EP—A—0 112 607 also falling within the terms of Art. 54(3), a vertical MOSFET is described, the gate electrode of which may be perforated between adjacent well regions in order to reduce the gate to drain capacitance.

EP—A—0 077 737 again falling under Art. 54(3), discloses a lateral MOSFET with a different configuration providing a shorter distance of the gate electrode from the channel region than from the drain and source regions.

Methods of manufacturing a vertical-type MOSFET are already known (GB—A—2 062 349 and US—A—4 072 975) by which a two-layer structure is formed and a primary mask layer is made of silicon oxide.

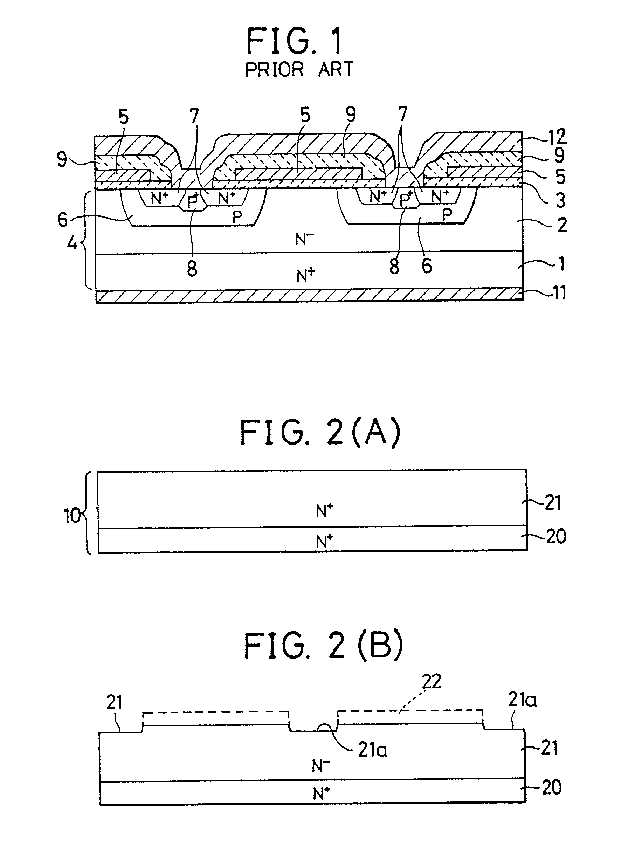

In Fig. 1 a typical cell or chip structure of a prior art vertical-type MOSFET is shown. The term "vertical" is derived from the fact that currents flow in the vertical direction of the transistor cell. The prior art vertical MOSFET cell is fabricated in accordance with the following fabrication processes;

a) An $N^-$-type layer of low impurity concentration is epitaxially grown on a drain substrate 1 of low resistivity comprised of an $N^+$-type silicon wafer of high impurity concentration to form a drain region 2 of high resistivity which defines a semiconductor wafer 4 together with the drain substrate 1.

b) An insulating coating 3 for a gate is formed on a principal surface of the drain region 2 of high resistance by a thermal oxidation method and then a polysilicon film constituting a gate electrode 5 is formed on the surface thereof.

c) The polysilicon film is selectively removed using photo-etching techniques to open source windows. Thereafter, under the condition that the remaining polysilicon film serves as a mask, through the opened source windows thus formed, there are successively formed by a double diffusion method a well region 6 functioning as channel and source and well contact regions 7 and 8, which diffuse concentrically within the well region 6 from the center thereof towards the outer periphery thereof.

d) After the double diffusion process is completed, a source electrode 12 is formed on the upper surface of the gate electrode 5 through an insulating film 9 by vacuum deposition. Further, a drain electrode 11 is formed on the rear side of the drain substrate 1 of low resistivity. Thus, the prior art vertical-type MOSFET cell shown in Fig. 1 is completed.

In the prior art vertical-type MOSFET to which the above-described method is applied, both the well region 6 and the source region 7 are formed by the double diffusion method. For this reason, when a large number of transistor elements are fabricated on the silicon wafer, following advantages will accrue. Namely, uniformity in characteristics of each transistor can be obtained. The production yield can be remarkably improved. The transistor device can be small-sized.

However, with the double diffusion method, after ion implantation is effected through the source windows with the polysilicon film constituting the gate electrode serving as a mask, it is necessary to in advance coat the whole area interposed between the adjacent source windows in order to form the well region and the source region by the double diffusion method.

For this reason, the completed transistor cell has the geometrical configuration in which the polysilicon film exists still in an area corresponding to the upper surface of the drain region, which area corresponds to areas or portions except for the upper surface of the channel region required for the gate electrode. From a structural view point, the gate electrode and the drain region are spaced from each other solely through the thin insulating film interposed therebetween. Accordingly, this results in large capacity between the drain and gate electrodes. Further, the capacity serves as a feedback circuit from the output of the switching element to the input thereof, thereby making it impossible or difficult to effect switching at a high speed.

With the above in view, it is an object of the invention to provide a vertical-type MOSFET making it possible and extremely reduce or lessen the capacity between the drain and the gate to effect switching at a high speed and wherein the prior art double diffusion method is directly applicable when fabricating the MOSFET of the invention in spite of a provision of an improvement for high switching capability thereof, thereby making it possible to fabricate it at a low cost without lowering the production yield even if transistor device elements are required to be integrated in a densely packed manner which is advantageous in the double diffusion method.

The object is accomplished by the features as claimed in the characterising parts of claims 1 and 5 and as claimed in method claim 7.

In accordance with the invention, the capacity between the drain and gate is reduced without providing adverse effects on the advantages based on the double diffusion method. The method is constituted so that the distance between the gate electrode and the drain region is larger than the distance between the gate electrode and well region functioning as channels.

Further developments of the invention are claimed in the subclaims.

Embodiments of a vertical-type MOSFET are explained in connection with the drawings in which

Fig. 1 is a cross-sectional view illustrating a typical structure of a prior art vertical-type MOSFET,

Figs. 2(A) to 2(I) are cross-sectional views illustrating a first embodiment of a vertical-type MOSFET element according to the present invention, each showing fabricating processes thereof,

Figs. 3(A) to 3(G) are cross-sectional views illustrating a second embodiment of the vertical-type MOSFET element according to the present invention, each showing fabricating processes thereof and

Figs. 4(A) to 4(H) are cross-sectional views illustrating a third embodiment of a vertical-type MOSFET element according to the present invention, each showing fabricating processes thereof.

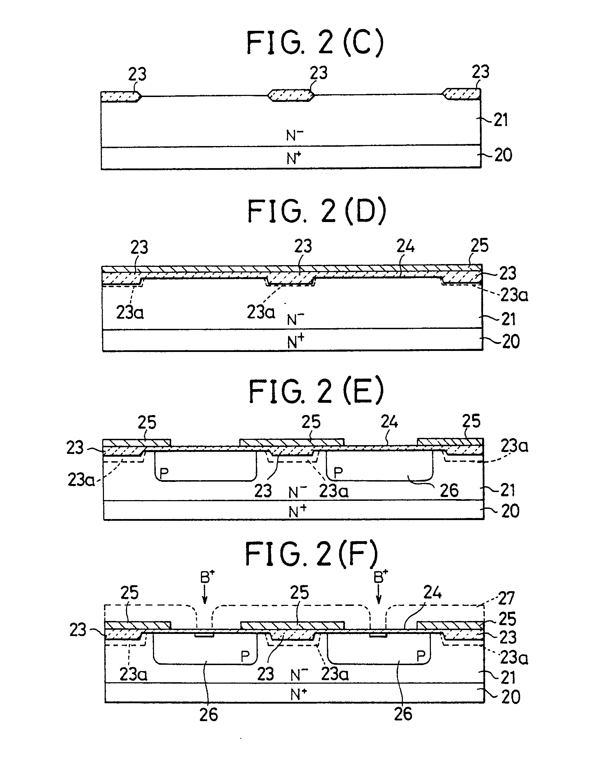

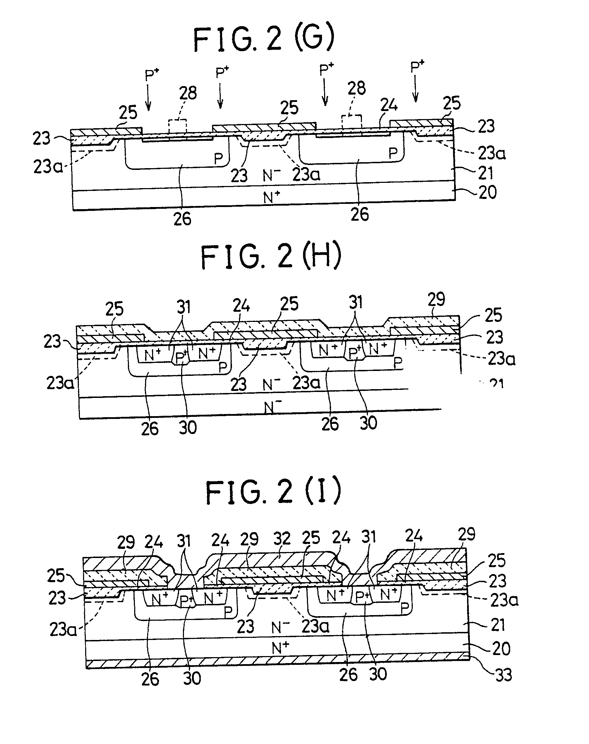

Referring to Fig. 2, there is shown the first embodiment of the invention. An example of fabricating processes or steps of an n-channel vertical-type MOSFET according to the first embodiment will be described with reference to Figs. 2(A) to 2(I).

Initially, as shown in Fig. 2(A), the method comprises the step of epitaxially growing an $N^-$-type monocrystalline silicon layer 21 of high resistivity, having low donor impurity concentration $N_D$ of about $2 \times 10^{15}$ atoms/cm$^3$ and thickness of about 15 µm, on a drain substrate 20 of low resistivity comprising an $N^+$-type monocrystalline silicon wafer of high concentration of donor impurities $N_D$ of about $1 \times 10^{18}$ atoms/cm$^3$ to form a drain region 21 of high resistivity. A semiconductor wafer 10 is defined by the drain substrate 20 and the drain region 21.

As shown in Fig. 2(B), the method further comprises the steps of covering or coating areas or portions, in which well regions for forming channels will be formed, with a resist 22 on an upper surface of the drain region 21 of high resistivity, effecting dryetching the surface of opened window portions form in the resist 22 by about 1µm to form recess portions 21a, and thereafter removing the resist 22.

As shown in Fig. 2(C), the method comprising the steps of depositing a silicon oxide film 23 including therein arsenic (As) having molecular concentration of about 3% by the CVD (Chemical Vapour Deposition) method so that the thickness thereof is 1 µm on the whole surface thereof, and removing the silicon oxide film 23 except for the recess portions 21a by photo-etching techniques. In this instance, the silicon oxide films 23 filled in the recess portions 21a is formed in such a manner that each upper end is projected from the surface of the drain region 21. More particularly, the silicon oxide films 23 having gradually inclined peripheral edges projected from the surface of the drain region 21.

As shown in Fig. 2(D), the method further comprises the steps of forming a silicon oxide film 24 for a gate on the surface of the drain region by thermal oxidation so that the thickness thereof is approximately $10^2$ nm (1,000 Å), and forming a polysilicon layer constituting a gate electrode 25 on the upper surface thereof by a CVD method. In this instance, N-type impurities of arsenic (As) contained in the silicon oxide film 23 provided within the recess portions 21a diffuses due to the thermal oxidation mentioned above. As shown by dotted lines, $N^+$-type regions 23a of high concentration are formed along the interface between the periphery of the silicon oxide film 23 and the drain region 21 of high resistivity.

As shown in Fig. 2(E), the method further comprises the steps of selectively removing by photo-etching techniques the portions of the polysilicon layer in which the well region will be formed, except for gate electrodes 25, effecting boron ion ($B^+$) implantation with the gate electrode portions 25 serving as a mask, and effecting heat treatment for 24 hours at a temperature of about 1,100°C, whereby a P-type well region 26 for forming channels having depth of 4 to 6 µm are formed. In this process, the energy for ion implantation is about 60 KeV, and the implanted quantity thereof is about $4 \times 10^{13}$ atoms/cm$^2$.

As shown in Fig. 2(F), the method further comprises the steps of effecting implantation of boron ion ($B^+$) from windows opened in the central portion of the upper surface of the well regions 26 with the resist 27 (shown by dotted line) serving as a mask, and removing the resist 27 upon completion of the ion implantation, whereby regions which will serve as P-type well contact regions are formed in the central portion of the well region 26. In this process, the energy for ion implantation is about 50 KeV, and the implanted quantity thereof is about $5 \times 10^{15}$ atoms/cm$^2$.

As shown in Fig. 2(G), the method comprises the steps of covering regions which will serve as P-type well contact regions with resists 28 (shown by dotted lines), and effecting ion implantation of phosphorus ion ($P^+$) with the resists 28 and the gate electrodes 25 serving as a mask. In this process, the energy for ion implantation is about 100 KeV, and the implanted quantity is $5 \times 10^{15}$ atoms/cm$^2$. The phosphorus ion is also entered into the polysilicon layer 25.

Upon finishment of the above-mentioned steps, resists 28 are removed. Thus, the regions which will serve as a source region including a phosphorus ion (P+) are formed along the periphery of the regions which will serve as the well contact region.

As shown in Fig. 2(H), the method comprises the steps of forming an insulating film 29 essentially consisting of phosphoric glass in which molecular concentration of phosphorus (P) is about 3% and the thickness thereof is $7 \times 10^2$ nm (7,000 A) so as to cover the whole surface, and effecting heat treatment in an atmosphere of nitrogen ($N_2$) at a temperature of about 1,050 C, whereby boron ion ($B^+$) and phosphorus ion ($P^+$) diffuse from the center to the periphery within the well region 26 to complete a P-type well contact region 30 and $N^+$-type source regions 31 respectively.

Finally, as shown in Fig. 2(I), the method further comprises the steps of opening windows for the surface of the source region 31 and the well contact region 30 as well as windows for the leading-out port (not shown) of the gate electrodes, thereafter coating aluminum (Al) on the surface thereof by vacuum deposition so that the thickness thereof is 1.5 μm, forming a source electrode 32 and a lead electrode for a gate (not shown) by etching, coating aluminum (Al) having the thickness of about 1 μm on the lower surface of the drain substrate 20 of low resistivity by vacuum deposition, and alloying the aluminum at a temperature of about 450°C, thereby to form a drain electrode 33. Thus, the completed vertical-type MOSFET of the first embodiment is obtained.

In the processes according to the first embodiment, the N-type impurity, such as, arsenic is mixed or included in the silicon oxide film 23 embedded in the drain region 21 of high resistivity, and then the silicon oxide film 24 is formed on the surface of the drain region 21 of high resistivity. In these processes, $N^+$-type regions 23a of high impurity concentration are formed along the boundary portions between the oxide film 23 and the drain region 21 of high resistivity by thermal diffusion. As a result, currents flow through the $N^+$-regions 23a, thereby making it possible to reduce resistance which originates in the drain region of high resistivity to lessen "ON" resistance in current path.

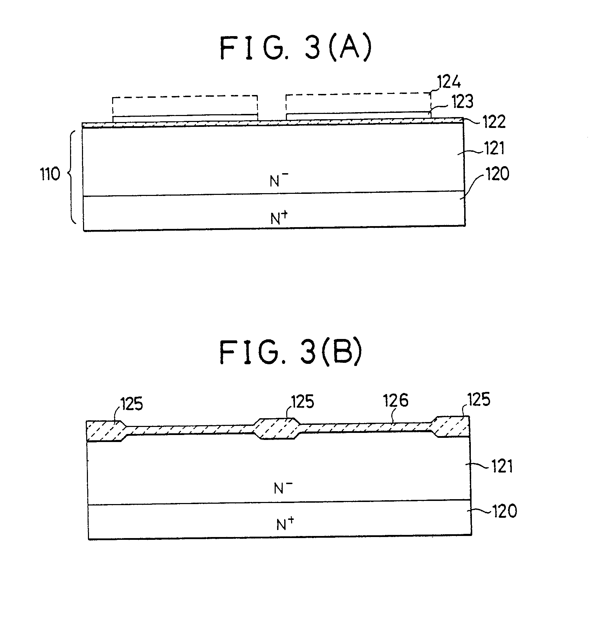

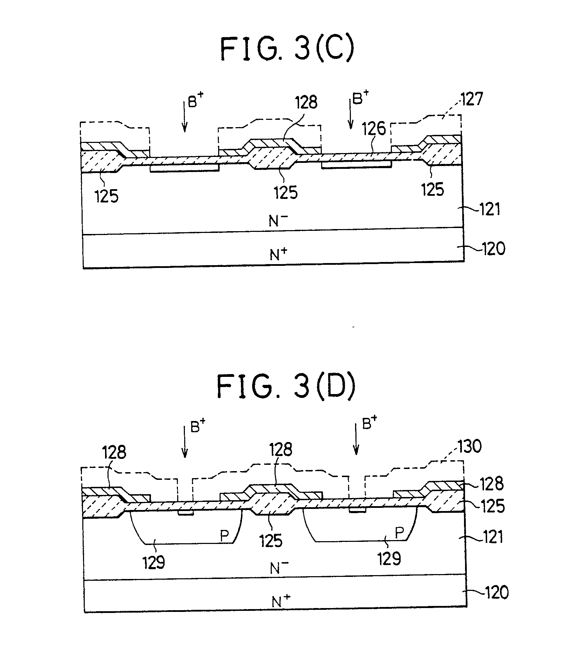

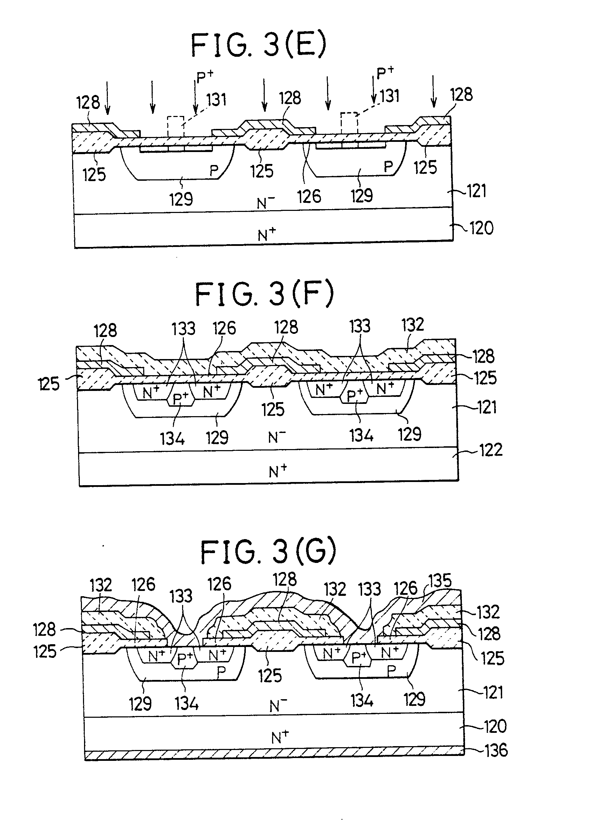

Referring to Figs. 3, there is shown the second embodiment of the invention. An example of the fabricating processes of an n-channel vertical-type MOSFET according to the second embodiment will be described with reference to Figs. 3(A) to 3(H).

Initially, as shown in Fig. 3(A), the method comprises the steps of epitaxially growing an $N^-$-type monocrystalline silicon layer 121 of low impurity concentration having donor concentration $N_D$ of about $2 \times 10^{15}$ atoms/cm$^3$ and the thickness of about 15 μm on a drain substrate 120 of low resistivity comprising an $N^+$-type monocrystalline silicon wafer of high concentration of donor impurities $N_D$ of about $1 \times 10^{18}$ atoms/cm$^3$,

thereby to form a drain region 121 of high resistivity, thereafter forming silicon nitride ($Si_3N_4$) film 123 on the surface of the drain region 121 of high resistivity of a semiconductor wafer 110 through a thin silicon oxide film 122 having the thickness of about $6 \times 10$ nm (600 A) by a CVD method so that the thickness of the silicon nitrode film 123 is about $10^2$ nm (1,000 A), and the removing silicon nitride film 123 except for portions in which well regions functioning as channels are to be formed with resists 124 (shown with dotted lines) serving as a mask.

As shown in Fig. 3(B), the method comprises the steps growing an silicon oxide film by a thermal oxidation method on the removed portions to form oxide insulating film regions 125 having the thickness of about 1 μm, then removing the silicon nitride films 123 and the resists 124 using phosphoric acid, at the same time removing the thin oxide film 122 located at the lower surface of the silicon nitride film 123, and thereafter forming a silicon oxide insulating film 126 for a gate on the surface of the drain region 121 of high resistivity except for the thick oxide film region 125 by a thermal oxidation method so that the thickness thereof is about $10^2$ nm (1,000 Å). In the process of growing the thick oxide insulating film region 125, each periphery of the region 125 grows in the upper and lower directions in such a manner as to push up the periphery portion of the silicon nitride film 123. Accordingly, the thick oxide insulating film regions 125 are formed in such a manner that each upper part is projected with respect to the surface of the insulating film 126 for a gate. More particularly, the oxide insulating films 125 are trapezoid-shaped in appearance, which have gradually inclined peripheral edges, respectively.

As shown in Fig. 3(C), after the selective oxidation process is completed, the method further comprises the steps of forming a polysilicon film 128 having the thickness of about $4 \times 10^2$ nm (4,000 Å) by a CVD method, selectively removing the polysilicon film by photo-etching techniques with resists 127 serving as a mask so that gate electrodes 128 are left, and injecting boron ions ($B^+$) into the portions in which there exist no gate electrode 128 on the upper surface of the drain region 121 of high resistivity by an ion implantation method with the gate electrodes 128 serving as a mask. The energy for ion implantation is about 60 KeV, and the implanted quantity is about $4 \times 10^{13}$ atoms/cm$^2$.

As shown in Fig. 3(D), the method further comprises effecting heat treatment for 24 hours at a temperature of about 1,100°C thereby to form well regions 129 having the depth of 5 to 6 μm by diffusion, and injecting boron ions ($B^+$) into a predetermined surface of the well regions 129 with the resists 130 (shown with dotted lines) serving as a mask. The energy for ion implantation is about 50 KeV, and the implanted quantity if $5 \times 10^{15}$ atoms/cm$^2$.

As shown in Fig. 3(E), the method further comprises the steps of covering with resists 131 the regions into which the boron ions (B⁺) have been injected in the preceding step, and then injecting phosphorus ions (P⁺) into the surface of the well region 129 with the resists 131 and the gate electrodes 129 serving as masks. In this instance, a great amount of phosphorus ions (P⁺) are immersed into the polysilicon films constituting the gate electrodes 128. The energy for ion implantation is about 100 KeV, and the implanted quantity is about $5 \times 10^{15}$ atoms/cm².

As shown in Fig. 3(F), after the above-described ion implantation is completed, the method further comprises the steps of forming an insulating film 132 essentially consisting of phosphoric glass having molecular concentration of about 3% by a CVD method so that the thickness thereof is $7 \times 10^2$ nm (7,000 Å), and effecting heat treatment in the presence of a current of nitrogen at a temperature of about 1,050°C, whereby source regions 133 and well contact regions 134 are formed within the well region 129 by thermal diffusion.

As shown in Fig. 3(G), after the double diffusion process described above is completed, the method further comprises the steps of opening windows exposed to the surface of the source regions 133 and the well contact region 134 as well as windows for the leading-out port (not shown) of the gate electrodes, then coating aluminum of about 1.5 μm in thickness by vacuum deposition, thereafter forming source electrode 135 and lead electrodes for a gate (not shown) by etching, coating aluminum having the thickness of 1 μm on the rear surface of the drain substrate 120 of low resistivity by vacuum deposition, and then effecting heat treatment at a temperature of about 450°C, whereby an alloy drain electrode 136 is formed. Thus, the vertical-type MOSFET shown in Fig. 3(G) of the second embodiment is completed.

According to the second embodiment, in the selective oxidation process shown in Fig. 3(B) the peripheral portion of the thick oxide insulating film region 125 rises so as to be gradually sloped surface. Accordingly, when the gate electrode 128, the insulating film 132 and the source electrode 135 are successively stacked, there occurs no crack between respective layers due to the offset structure by the gentle slopes thereof. Further, the stress applied to each films of the layers can become substantially uniform throughout the whole portion of each film.

Further, in the selective oxidation process shown in Figs. 3(A) and 3(B) in the second embodiment, another method may be employed, which comprises the steps of effecting arsenic ions (As) implantation with a resist 124 serving as a mask into the surface of the drain region 121 of high resistivity, and then forming a thick oxide insulating film region 125 and then forming a thick oxide insulating film region 125 in the same portions as stated above.

The arsenic ions (As) thus implanted form an N⁺-type region of high impurity concentration along the interface between the insulating film region 125 and the drain region 121 of high resistivity by thermal diffusion in Fig. 3(G). Accordingly, similar to the first embodiment, electric currents flow through the N⁺-type region, thereby making it possible to reduce resistance which originates in the drain region of high resistivity to lessen "ON" resistance in current paths.

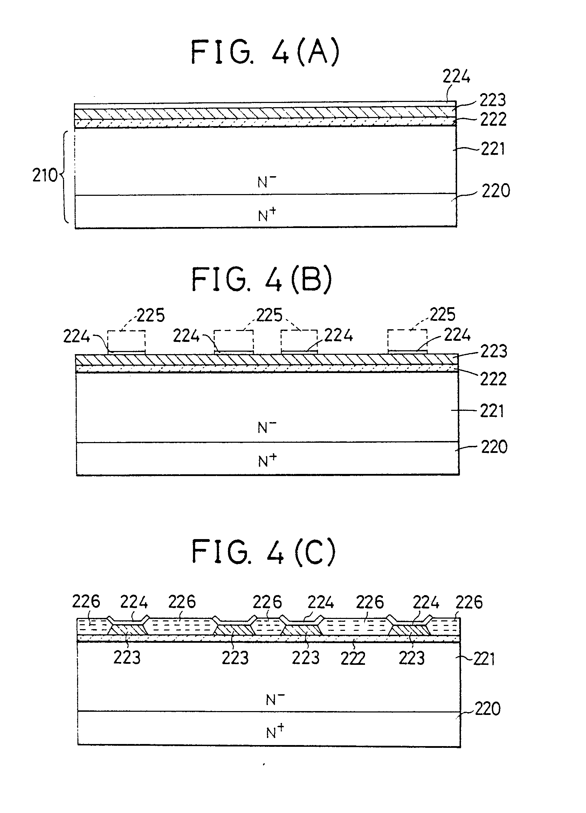

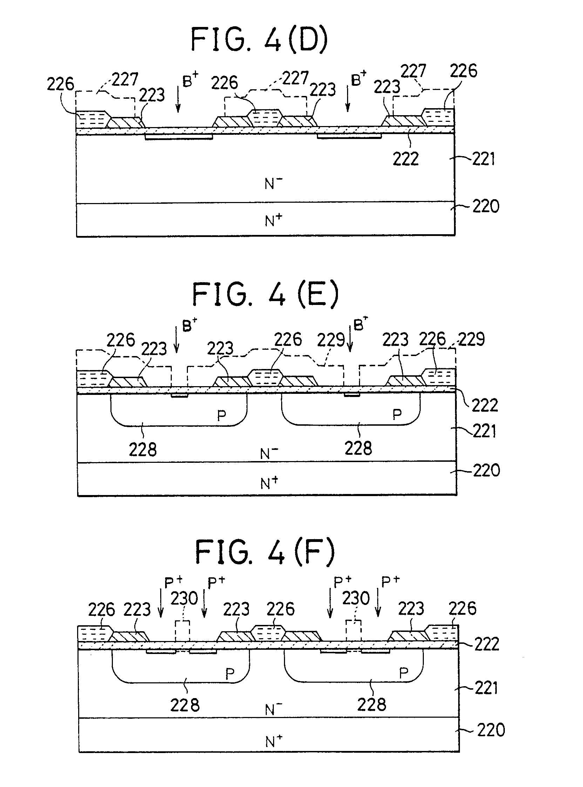

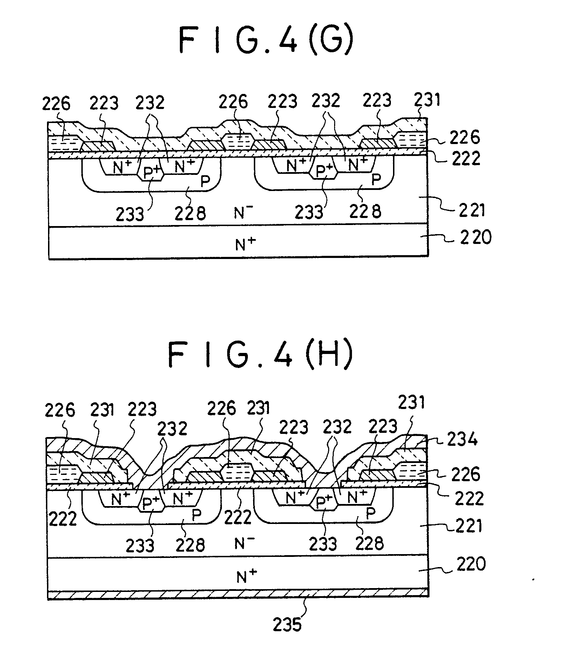

Referring to Fig. 4, there is shown the third embodiment of the invention. An example of fabricating processes of an N-channel vertical type MOSFET according to the third embodiment will be described with reference to Figs. 4(A) to 4(H).

Initially, as shown in Fig. 4(A), the method comprises the steps of epitaxially growing an N⁻-type monocrystalline silicon layer of low impurity concentration having donor concentration $N_D$ of about $2 \times 10^{15}$ atoms/cm³ and the thickness of about 15 μm on a drain substrate 220 of low resistivity essentially consisting of an N⁺-type monocrystalline silicon wafer of high impurity concentration having donor concentration $N_D$ of about $1 \times 10^{18}$ atoms/cm³ thereby to form a drain region 221 of high resistivity, forming a silicon oxide insulating film 222 for a gate on the surface of the drain region 221 of high resistivity of a semiconductor wafer 210 by a thermal oxidation method so that the thickness thereof is about $10^2$ nm (1,000 Å), thereafter forming a polysilicon film 223 having the thickness of $4 \times 10^2$ nm (4,000 Å) by a CVD method and forming a silicon nitride film (Si₃N₄) 224 on the surface thereof by a CVD method so that the thickness thereof is about 10 nm (1,000 Å).

As shown in Fig. 4(B), the method further comprises the step of selectively removing the silicon nitride film 224 with resists 225 (shown with dotted lines) serving as masks. The removed portions of the film 224 correspond to the portions of the drain region 221 that is to interpose between two well regions and the portions that is to be source regions.

As shown in Fig. 4(C), the method further comprises the step of oxidizing the polysilicon film 223 except for the gate electrode portions by thermal oxidation to change them into silicon oxide films 226. In this oxidation process, the silicon oxide insulating film 226 grows in a manner to push up the opened inner peripheral edge in the window provided in the silicon nitride film 224. Accordingly, the insulating films 226 rise on the surface so as to have trapezoidal shape in cross section.

As shown in Fig. 4(D), after the above-mentioned selective oxidation process is finished, the method further comprises the steps of removing the silicon nitride film 224 by photo-etching techniques, selectively removing the polysilicon oxide insulating films 226 which coat the portions in which the well regions will be formed, covering the upper surface of the gate electrodes 223 and the insulating films 226 with resists 227 (shown with dotted line), and injecting boron ions (B⁺) into the surface of the drain region 221 of high resistivity by an ion implantation method under the condition that the gate electrode 223 and the resists 227 serve as a mask. The energy for ion implantation is about 60 KeV, and the implanted quantity is about $4 \times 10^{13}$ atoms/cm$^2$.

As shown in Fig. 4(E), the method further, comprises the steps of effecting heat treatment for 24 hours at a temperature of 1,100°C to form P well regions 228 by thermal diffusion, and injecting boron ions (B$^+$) into the surface of the well region 228 from windows opened in the center thereof with the resists 229 serving as masks. The energy for ion implantation is about 50 KeV, and the implanted quantity if about $5 \times 10^{15}$ atoms/cm$^2$.

As shown in Fig. 4(F), the method further comprises the steps of covering the region into which the boron ions are injected at the preceding process with resists 230, and injecting phosphorus ions (P$^+$) into the well regions 228 with the resist 230, the silicon film 223 and the insulating film 226 serving as a mask. In this instance, a great amount of phosphorus ions are entered into the gate electrode 223. The energy for ion implantation is about 100 KeV, and the implanted quantity is about $5 \times 10^{15}$ atoms/cm$^2$.

As shown in Fig. 4(G), the method further comprises the steps of forming an insulating film 231 essentially consisting of phosphoric glass, the molecular concentration of phosphorus being about 3%, by a CVD method so that the thickness thereof is $7 \times 10^2$ cm (7,000 Å), and effecting heat treatment in the atmosphere of nitrogen at a temperature of about 1,050°C, whereby source regions 232 and well contact regions 233 are formed within the well region 228 by thermal diffusion.

Finally, as shown in Fig. 4(H), after the thermal diffusion process is finished, the method further comprises the steps of opening windows in the insulating films 222, 231 for forming electrodes on the source regions 232 and well contact regions 233, opening window in the insulating film 231 for leading-out ports of gate electrodes (not shown), coating aluminum on the whole surface thereof by vacuum deposition so that the thickness thereof is 1.5 μm, forming a source electrode 234, and a lead electrode (not shown), for a gate by etching, thereafter coating aluminum having the thickness of about 1 μm on the whole rear surface of the wafer 210 by vacuum deposition, and alloying it at a temperature of about 450°C thereby to form a drain electrode 235. Thus, the vertical MOSFET of the third embodiment shown in Fig. 4(H) is completed.

In the selective oxidation process shown in Fig. 4(C), the oxide insulating film 226 rises so as to be gradual inclined at its surface. In the case where the insulating film 231 and the source electrode 234 are successively stacked as described above and illustrated in the figures, there occurs no crack between layers due to offset structure by the gentle slopes thereof. Further, the stresses applied to the films of each layers can became substantial uniform as well as the thicknesses thereof.

In the selective oxidation process shown in Figs. 4(C), similar to the second embodiment, another method may be employed, which comprises the steps of injecting an N-type impurity, such as phosphorus ions (P$^+$) into the silicon polycrystalline 223 with the resists 225 by an ion implantation method in advance. As described above the MOS transistor produced according to this method makes it possible to reduce resistance due to the drain region of high resistivity, thereby to lessen resistance in current paths when the element is switched on.

In the above-mentioned embodiments, the P-type well region is formed on the N-type substrate. However, the present invention is applicable to a P-channel vertical-type MOSFET that an N-type well region is formed on a P-type substrate.

As appreciated from the detailed description in connection with the preferred embodiments, the vertical-type MOSFET according to the present invention is constituted so as to increase the effective distance between the gate electrode film and the drain region in the central portion of the gate electrode film located between adjacent well regions for forming a channel. Accordingly, this makes it possible to remarkably decrease feedback capacity between the gate and the drain, thereby to effect switching at a high speed.

**Claims**

1. A vertical-type MOSFET comprising:
a semiconductor wafer (10; 110) functioning as drain region (21; 121),
a drain electrode (33; 136) joined to the lower surface of said wafer,
a plurality of well regions (26; 129) formed in the upper surface of said wafer spaced from each other,
a plurality of source regions (31; 133) each of which is formed in one of said well regions respectively,
a gate electrode (25; 128) formed on said adjacent well regions and the portion of said wafer between said adjacent well regions and separated from the upper surface of said wafer by a gate insulating film (24; 126) and a source electrode (32; 135) electrically contacting said source regions, characterised in that the distance between said gate electrode (25; 128) and the central portion of said portion of said wafer (10; 110) is larger than the distance between said gate electrode and said well regions (26; 129).

2. A vertical-type MOSFET as claimed in claim 1, wherein said gate insulating film (126) is locally thicker at the part corresponding to said central portion of said wafer (110) than outside this part.

3. A vertical-type MOSFET as claimed in claim 2, wherein said thicker part (125) of the film (126) rises so as to form a gently sloped surface on said wafer (110).

4. A vertical-type MOSFET as claimed in claim 1, wherein additional insulator portions (23) are located between said central portions of said wafer (10) and said gate electrode (25) so that the distance between said gate electrode (25) and said central portions of said wafer (10) is larger than the distance between said gate electrode (25) and said well regions (26).

5. A vertical-type MOSFET comprising:
a semiconductor wafer (210) functioning as drain region (221),

a drain electrode (235) joined to the lower surface of said wafer,

a plurality of well regions (228) formed in the upper surface of said wafer spaced from each other,

a plurality of source regions (232) each of which is formed in one of said well regions respectively,

a gate electrode (223) formed on said adjacent well regions and separated from said well regions by a gate insulating film (222) and a source electrode (234) formed on said source regions, characterized in that an insulating portion (226) is located between and spaced from said adjacent well regions (228) and in that said insulating portion is

established by thermal oxidation of the corresponding part of a conductive film the remaining part of which forms said gate electrode (223).

6. A vertical-type MOSFET as claimed in claim 5, wherein said insulating portion (226) rises so as to form a gently sloped surface on said wafer (210).

7. A method of manufacturing a vertical-type MOSFET as claimed in claim 2 comprising

(A) the step of forming a silicon oxide film (126) on the upper surface of a semiconductor wafer (110) in a manner that the thickness of the portions (125) thereof which are to be located between adjacent well regions (129) is larger than that outside these portions,

(B) the step of forming gate electrode (128) on said silicon oxide film,

(C) the step of forming said well regions by an ion implantation method with said gate electrodes functioning as a mask,

(D) the step of forming source regions (122) in said well regions with said gate electrodes functioning as a mask,

(E) the step of forming source electrodes (135) on said source regions and a drain electrode (136) on the lower surface of the semiconductor wafer.

8. A method as claimed in claim 7, wherein said portions (125) of said silicon oxide film (126) are formed so as to rise from said wafer (110) forming a gently sloped surface.

9. A method as claimed in claim 7, wherein said silicon oxide film (126) is formed in a manner that said portions (125) include therein impurities of the conductivity type corresponding to that of said wafer at the step (A).

10. A method of manufacturing a vertical-type MOSFET as claimed in claim 4 comprising

(A) the step of forming recess portions (21a) on the upper surface of a semiconductor wafer (10),

(B) the step of depositing insulator portions (23) in each of said recess portions,

(C) the step of forming a silicon oxide film (24) and a polysilicon layer (25) on the whole upper surface of said semiconductor wafer in the manner that said polysilicon layer is insulated from said wafer by said silicon oxide film and said deposited insulator portions,

(D) the step of selectively removing the portions of said polysilicon layer corresponding to the portions of said wafer in which source regions (31) are to be formed,

(E) the step of effecting ion implantation in said portions of said wafer corresponding to said removed portion and forming well regions (26) by a heat treatment,

(F) the step of effecting ion implantation in said portions of said wafer corresponding to said removed portion and forming source regions by a heat treatment.

(G) the step of forming source electrodes (32) on said source regions and a drain electrode (33) on the lower surface of said wafer.

11. A method as claimed in claim 10, wherein said insulator portions (23) deposited in said recess portions (21a) include therein impurities of the conductivity type corresponding to that of said wafer (10).

12. A method of manufacturing a vertical-type MOSFET as claimed in claim 5 comprising

(A) the steps of forming a silicon oxide film (222) and a polysilicon film (223) stacked on said silicon oxide film on the upper surface of a silicon wafer (210),

(B) the step of selectively oxidizing said polysilicon film except for the gate electrode portions including the portions that are to be located between and spaced from adjacent well regions,

(C) the step of removing said oxidized portions (226) facing to the portions of said wafer that are to be source regions (232),

(D) the step of forming said well and source regions (228, 232), each of said source regions formed in one of said well regions respectively,

(E) the step of forming source electrodes (234) on said source regions and a drain electrode (235) on the lower surface of said wafer.

13. A method as claimed in claim 12, wherein said well and source regions (228, 232) are formed by the ion implantation method and thermal diffusion and said portions (226) of said oxidized polysilicon film are doped with impurities of the conductivity type corresponding to said wafer prior to said thermal diffusion.

**Patentansprüche**

1. Vertikaler MOSFET mit
einer Halbleiter-Platte (10; 110), die als Drain-Bereich (21; 121) wirkt,

einer Drain-Elektrode (33; 136), die mit der unteren Fläche der Platte vereinigt ist,

mehreren Potentialtopf-Bereichen (26; 129), die in der oberen Fläche der Platte mit Abstand voneinander ausgebildet sind,

mehreren Source-Bereichen (31; 133), von denen jeder in einem der Potentialtopf-Bereiche ausgebildet ist,

einer Gate-Elektrode (25; 128), die auf den benachbarten Potentialtopf-Bereichen und dem Teil der Platte zwischen den benachbarten Potentialtopf-Bereichen sowie von der Oberen Fläche der Platte durch einen Gate-Isolationsfilm (24; 126) getrennt ausgebildet ist, und

einer Source-Elektrode (32; 135), die die Source-Bereiche elektrisch kontaktiert,

dadurch gekennzeichnet, daß

die Entfernung zwischen der Gate-Elektrode (25; 128) und dem Mittelteil des genannten Teils der Platte (10; 110) größer als die Entfernung zwischen der Gate-Elektrode und den Potentialtopf-Bereichen (26; 129) ist.

2. Vertikaler MOSFET nach Anspruch 1, wobei der Gate-Isolationsfilm (126) an dem dem Mittelteil der Platte (110) entsprechenden Teil örtlich dicker als außerhalb dieses Teils ist.

3. Vertikaler MOSFET nach Anspruch 2, wobei der dickere Teil (125) des Films (126) derart ansteigt, daß er eine sanft geneigte Fläche auf der Platte (110) bildet.

4. Vertikaler MOSFET nach Anspruch 1, wobei zusätzliche Isolationsteile (23) zwischen den Mittelteilen der Platte (10) und der Gate-Elektrode (25) derart angeordnet sind, daß die Entfernung zwischen der Gate-Elektrode (25) und den Mittelteilen der Platte (10) größer als die Entfernung zwischen der Gate-Elektrode (25) und den Potentialtopf-Bereichen (26) ist.

5. Vertikaler MOSFET mit

einer Halbleiter-Platte (210), die als Drain-Bereich (221) wirkt,

einer Drain-Elektrode (235), die mit der unteren Fläche der Platte verreinigt ist,

mehreren Potentialtopf-Bereichen (228), die in der oberen Fläche der Platte mit Abstand voneinander ausgebildet sind,

mehreren Source-Bereichen (232), von denen jeder in einem der Potentialtopf-Bereiche ausgebildet ist,

einer Gate-Elektrode (223), die auf den benachbarten Potentialkopf-Bereichen und von diesen Potentialtopf-Bereichen durch einen Gate-Isolationsfilm (222) getrennt ausgebildet ist, und

einer Source-Elektrode (234), die auf den Source-Bereichen ausgebildet ist,

dadurch gekennzeichnet, daß

eine Isolationsteil (226) zwischen und beabstandet von den benachbarten Potentialtopf-Bereichen (228) angeordnet ist und daß

das Isolationsteil durch thermische Oxidation des entsprechenden Teils eines leitenden Films erhalten ist, dessen übriger Teil die Gate-Elektrode (223) bildet.

6. Vertikaler MOSFET nach Anspruch 5, wobei der Isolationsteil (226) derart ansteigt, daß er eine sanft geneigte Fläche auf der Platte (210) bildet.

7. Verfahren zum Herstellen eines vertikalen MOSFET, wie er im Anspruch 2 beansprucht ist, das aufweist:

(A) einen Schritt zum Bilden eines Siliciumoxidfilms (126) auf der oberen Fläche einer Halbleiter-Platte (110) derart, daß die Dicke seiner Teile (125), die zwischen benachbarten Potentialtopf-Bereichen (129) angeordnet sind, größer ist als die außerhalb dieser Teile,

(B) einen Schritt zur Bildung von Gate-Elektroden (128) auf dem Siliciumoxidfilm,

(C) einen Schritt zum Bilden der Potentialtopf-Bereiche durch das Ionenimplantierungsverfahren, bei dem die Gate-Elektroden als eine Maske wirken,

(D) einen Schritt zum Bilden von Source-Bereichen (133) in den Potentialtopf-Bereichen, wobei die Gate-Elektroden als eine Maske wirken, und

(E) einen Schritt zum Bilden von Source-Elektroden (135) auf den Source-Bereichen und einer Drain-Elektrode (136) auf der unteren Fläche der Halbleiter-Platte.

8. Verfahren nach Anspruch 7, wobei die Teile (125) des Siliciumoxidfilms (126) derart gebildet werden, daß sie von der Platte (110) aus ansteigen, um eine sanft geneigte Fläche zu bilden.

9. Verfahren nach Anspruch 7, wobei der Siliciumoxidfilm (126) derart gebildet wird, daß die Teile (125) in sich Verunreinigungen des Leitungstyps umfassen, der dem der Platte beim Schritt (A) entspricht.

10. Verfahren zum Herstellen eines vertikalen MOSFET, wie er im Anspruch 4 beansprucht ist, das aufweist:

(A) einen Schritt zum Bilden von Ausnehmungsteilen (21a) auf der oberen Fläche einer Halbleiter-Platte (10),

(B) einen Schritt zum Ablagern von Isolationsteilen (23) in jedem der Ausnehmungsteile,

(C) einen Schritt zum Bilden eines Siliciumoxidfilms (24) und einer Polysiliciumschicht (25) auf der gesamten oberen Fläche der Halbleiter-Platte derart, daß die Polysiliciumschicht von der Platte durch den Siliciumoxidfilm und die abgelagerten Isolationsteile isoliert ist,

(D) einen Schritt zum selektiven Entfernen der Teile der Polysiliciumschicht, die den Teilen der Platte entsprechen, in denen Source-Bereiche (31) gebildet werden sollen,

(E) einen Schritt zum Bewirken einer Ionenimplantation in den Teilen der Platte, die den entfernten Teilen entsprechen, und zum Bilden von Potentialtopf-Bereichen (26) durch ein Wärmebehandlung,

(F) einen Schritt zum Bewirken einer Ionenimplantation in den Teilen der Platte, die den entfernten Teilen entsprechen, und zum Bilden von Source-Bereichen durch eine Wärmebehandlung und

(G) einen Schritt zum Bilden von Source-Elektroden (32) auf den Source-Bereichen und einer Drain-Elektrode (33) auf der unteren Fläche der Platte.

11. Verfahren nach Anspruch 10, wobei die in den Ausnehmungsteilen (21a) abgelagerten Isolationsteile in sich Verunreinigungen des Leitungstyps enthalten, der dem der Platte (10) entspricht.

12. Verfahren zum Herstellen eines vertikalen MOSFET, wie er im Anspruch 5 beansprucht ist, das aufweist:

(A) Schritte zum Bilden eines Siliciumoxidfilms (222) und eines Polysiliciumfilms (223), der auf dem Siliciumoxidfilm auf der oberen Fläche einer Siliciumfilm-Platte (210) aufgeschichtet ist,

(B) einen Schritt zum selektiven Oxidieren des Polysiliciumfilms mit Ausnahme der Gate-Elektrodenteile, die die Teile umfassen, die zwischen und mit Abstand von den benachbarten Potentialtopf-Bereichen angeordnet sind,

(C) einen Schritt zum Entfernen der oxidierten Teile (226), die den Teilen der Platte zugewandt sind, die Source-Bereiche (232) werden sollen,

(D) einen Schritt zum Formen von Potentialtopf- und Source-Bereichen (228, 232), wobei jeder der Source-Bereiche in einem der Potentialtopf-Bereiche jeweils gebildet ist, und

(E) einen Schritt zum Bilden von Source-Elektroden (234) auf den Source-Bereichen und einer Drain-Elektrode (235) auf der unteren Fläche der Platte.

13. Verfahren nach Anspruch 12, wobei die Potentialtopf- und Source-Bereiche (228, 232) durch das

Ionenimplantationsverfahren und thermische Diffusion gebildet werden, und die Teile (226) des oxidierten Polysiliciumfilms mit Verunreinigungen des Leitungstyps dotiert werden, der dem der Platte vor der thermischen Diffusion entspricht.

**Revendications**

1. MOSFET du type vertical comprenant:
une pastille de semiconducteur (10; 110) fonctionnant comme région de drain (21; 121),
une électrode de drain (33, 136) jointe à la surface inférieure de ladite pastille,
un certain nombre de régions de puits (26; 129) formées à la surface supérieure de ladite pastille et espacées les unes des autres,
un certain nombre de régions de source (31; 133), dont chacune est formée respectivement dans l'une desdites régions de puits,
une électrode de porte (25; 128) formée sur lesdites régions adjacentes de puits et la portion de ladite pastille entre lesdites régions adjacentes de puits et séparée de la surface supérieure de ladite pastille par un film d'isolement de porte (24; 126) et une électrode de source (32; 135) contactant électriquement lesdites régions de source, caractérisé en ce que la distance entre ladite électrode de porte (25; 128) et la portion centrale de ladite portion de ladite pastille (10; 110) est plus grande que la distance entre ladite électrode de porte et lesdites régions de puits (26; 129).

2. MOSFET du type vertical selon la revendication 1, où ledit film isolant de porte (126) est localement plus épais à la partie correspondant à ladite portion centrale de ladite pastille (110) en dehors de cette partie.

3. MOSFET du type vertical selon la revendication 2, où ladite partie plus épaisse (125) du film (126) monte afin de former une surface légèrement en pente sur ladite pastille (110).

4. MOSFET du type vertical selon la revendication 1, où des portions isolantes supplémentaires (23) sont placées entre lesdites portions centrales de ladite pastille (10) et ladite électrode de porte (25) de manière que la distance entre ladite électrode de porte (25) et lesdites portions centrales de ladite pastille (10) soit plus grande que la distance entre ladite électrode de porte (25) et lesdites régions de puits (26).

5. MOSFET du type vertical comprenant:
une pastille de semiconducteur (210) servant de région de drain (221),
une électrode de drain (235) jointe à la surface inférieure de ladite pastille,
un certain nombre de régions de puits (228) formées à la surface supérieure de ladite pastille, espacées les unes des autres,
un certain nombre de régions de source (232), dont chacune est formée dans l'une desdites régions de puits respectivement,
une électrode de porte (223) formée sur lesdites régions adjacentes de puits et séparée desdites régions de puits par un film d'isolement de porte (222) en une électrode de source (234) formée sur lesdites régions de source,
caractérisé en ce qu'une portion isolante (226) est placée entre et est espacée desdites régions adjacentes de puits (228) et en ce que ladite portion isolante est établie par oxydation thermique de la partie correspondante d'un film conducteur dont la partie restante forme ladite électrode de porte (223).

6. MOSFET du type vertical selon la revendication 5, où ladite portion isolante (226) monte afin de former une surface légèrement en pente sur ladite pastille (210).

7. Procédé de fabrication d'un MOSFET du type vertical selon la revendication 2 comprenant
(A) l'étape de former un film d'oxyde de silicium (126) à la surface supérieure d'une pastille de semiconducteur (110) de manière que l'épaisseur des portions (125) qui doivent être placées entre des régions adjacentes de puits (129) soit plus grande qu'à l'extérieur de ces portions,
(B) l'étape de former des électrodes de porte (128) sur ledit film d'oxyde de silicium,
(C) l'étape de former lesdites régions de puits par la méthode d'implantation d'ions avec lesdites électrodes de porte servant de masque,
(D) l'étape de former des régions de source (133) dans lesdites régions de puits avec lesdites électrodes de porte servant de masque,
(E) l'étape de former des électrodes de source (135) sur lesdites régions de source et une électrode de drain (136) à la surface inférieure de la pastille de semiconducteur.

8. Procédé selon la revendication 7, où lesdites portions (125) dudit film d'oxyde de silicium (126) sont formées afin de monter de ladite pastille (110) en formant une surface doucement en pente.

9. Procédé selon la revendication 7, où ledit film d'oxyde de silicium (126) est formé de manière que lesdites portions (125) contiennent des impuretés du type de conductivité correspondant à celui de la pastille à l'étape (A).

10. Procédé de fabrication d'un MOSFET du type vertical selon la revendication 4 comprenant

(A) l'étape de former des parties évidées (21a) à la surface supérieure d'une pastille de semiconducteur (10),

(B) l'étape de déposer des portions isolantes (23) dans chacune desdites portions évidées,

(C) l'étape de former un film d'oxyde de silicium (24) et une couche de polysilicium (25) sur la totalité de la surface supérieure de ladite pastille de semiconducteur de manière que ladite couche de polysilicium soit isolée de ladite pastille par ledit film d'oxyde de silicium et lesdites portions isolantes déposées,

(D) l'étape d'enlever sélectivement les portions de la couche de polysilicium correspondant aux portions de ladite pastille où doivent être formées des régions de source (31),

(E) l'étape d'effectuer l'implantation d'ions dans lesdites portions de ladite pastille correspondant à ladite portion enlevée et de former des régions de puits (26) par un traitement thermique,

(F) l'étape d'effectuer l'implantation d'ions dans lesdites portions de ladite pastille correspondant à ladite portion enlevée et de former des régions de source par un traitement thermique,

(G) l'étape de former des électrodes de source (32) sur lesdites régions de source et une électrode de drain (33) à la surface inférieure de ladite pastille.

11. Procédé selon la revendication 10, où lesdites portions isolantes (23) déposées dans lesdites portions évidées (21a) contiennent des impuretés du type de conductivité correspondant à celui de ladite pastille (10).

12. Procédé de fabrication d'un MOSFET du type vertical selon la revendication 5 comprenant

(A) les étapes de former un film d'oxyde de silicium (222) et un film de polysilicium (223) empilé sur ledit film d'oxyde de silicium à la surface supérieure d'une pastille de silicium (210),

(B) l'étape d'oxyder sélectivement ledit film de polysilicium à l'exception des portions d'électrode de porte contenant les portions qui doivent être placées entre et espacées de régions adjacentes de puits,

(C) l'étape d'enlever lesdites portions oxydées (226) faisant face aux portions de ladite pastille qui doivent être des régions de source (232),

(D) l'étape de former lesdites régions de puits et de source (228, 232), chacune desdites régions de source étant formée dans l'une desdites régions de puits respectivement,

(E) l'étape de former des électrodes de source (234) sur lesdites régions de source et une électrode de drain (235) sur la surface inférieure de ladite pastille.

13. Procédé selon la revendication 12, où lesdites régions de puits et de source (228, 232) sont formées par la méthode d'implantation d'ions et la diffusion thermique et lesdites portions (226) dudit film de polysilicium oxydé sont dopées d'impuretés du type de conductivité correspondant à ladite pastille avant ladite diffusion thermique.

# FIG. 1
### PRIOR ART

# FIG. 2(A)

# FIG. 2(B)

# FIG. 2 (C)

23     23     23

21

N⁻

N⁺ — 20

# FIG. 2 (D)

23     23     24     25

23

23a

23a    23a   N⁻    21

N⁺ — 20

# FIG. 2 (E)

25     25     24     25

23                   23a

23a   P        P

23   N⁻   23a     26    21

N⁺ — 20

# FIG. 2 (F)

B⁺        B⁺

25     25     24 — 27

25

23                   23

      P        P    23a

23a     23   N⁻   23a     21

N⁺ — 20

26        26

# FIG. 2 (G)

# FIG. 2 (H)

# FIG. 2 (I)

3

# F I G. 3 (A)

```
                                    124
                                    123
                                    122
            110 {          N⁻       121
                                    120
                          N⁺
```

# F I G. 3 (B)

```
     125        125      126      125

                  N⁻              121

                 N⁺               120
```

# FIG. 3(C)

# FIG. 3(D)

# FIG. 3(E)

# FIG. 3(F)

# FIG. 3(G)

# FIG. 4(A)

# FIG. 4(B)

# FIG. 4(C)

7

# FIG. 4 (D)

# FIG. 4 (E)

# FIG. 4 (F)

# F I G. 4 (G)

226   223   232        226   223   232      223   231

226
222

N⁺  P⁺  N⁺            N⁺  P⁺  N⁺
              P                      P

233    228    N⁻        233    228

221

N⁺
220

# F I G. 4 (H)

226  231  223        226  231
              232            223   232   223   231

234
226
222

222  N⁺ P⁺ N⁺      222  N⁺ P⁺ N⁺
              P                    P

221

233  228    N⁻        233  228
220

N⁺

235